# EUROPÄISCHE PATENTANMELDUNG

(11) **EP 2 104 138 A1**
(43) Veröffentlichungstag der Anmeldung: **23.09.2009**
(21) Anmeldenummer: 08005016.4
(22) Anmeldetag: 18.03.2008
(51) Int. Cl.: H01L 21/98, H01L 21/68

(54) **Verfahren zum Bonden von Chips auf Wafer**

(71) Anmelder: EV Group E. Thallner GmbH, 4782 St. Florian (AT)
(72) Erfinder: Wimplinger, Markus, 4910 Ried Im Innkreis (AT)
(74) Vertreter: Schweiger, Johannes

(57) **Zusammenfassung**

Die Erfindung betrifft ein Verfahren zum Bonden einer Vielzahl von Chips (9) auf einen Basiswafer (1), wobei die Chips in mehreren Schichten über dem Basiswafer gestapelt werden und zwischen den vertikal benachbarten Chips sowie dem Basiswafer und der dem Basiswafer vertikal benachbarten Schicht von Chips elektrisch leitfähige Verbindungen (7) bestehen, mit folgenden Schritten in der genannten Reihenfolge:
a) Fixieren des Basiswafers auf einem Träger (5),
b) Platzieren mindestens einer Schicht von Chips in definierten Positionen auf dem Basiswafer und
c) Wärmebehandlung der Chips auf dem mit dem Träger fixierten Basiswafer.

## Beschreibung

Die Erfindung betrifft ein Verfahren gemäß Patentanspruch 1.

Auf Grund des in der Halbleiterindustrie vorherrschenden Miniaturisierungsdrucks werden Verfahren benötigt, mit welchen sogenannte "3D Integrated Chips" (3D IC) hergestellt werden können. Die 3D ICs bestehen aus Chipstapeln, bei welchen mehrere Chips vertikal übereinander gestapelt sind und Verbindungen durch das Silizium hindurch zu den vertikal benachbarten Chips bestehen. Die Verbindungen werden als "Through Silicon Vias" (TSV) bezeichnet.

Von solchen Chips erwartet man sich eine höhere Packungsdichte sowie eine höhere Leistungsfähigkeit bei niedrigeren Kosten. Darüber hinaus können hierdurch neue Arten und Formen von Chips hergestellt werden. Für die Herstellung der 3D ICs kommen grundsätzlich verschiedene Verfahren in Frage, nämlich das sehr zeitaufwendige Stapeln einzelner Chips auf einzelne Chips, auch als "Chip to Chip" (C2C)-Verfahren bezeichnet oder das Stapeln von Wafer auf Wafer, auch als "Wafer to Wafer" (W2W)-Verfahren bezeichnet. Schließlich wird auch das sogenannte Chip auf Wafer-Verfahren, "Chip to Wafer" (C2W), diskutiert. Eine vernünftige technische Umsetzung ist bisweilen auf Grund erheblicher technischer Probleme nicht gelungen. Die vorliegende Erfindung bezieht sich auf ein technisch ausführbares C2W-Verfahren zur Herstellung von 3D ICs.

C2C-Verfahren verursachen auf Grund des niedrigen Durchsatzes höhere Produktionskosten und dürften in der Massenproduktion daher kaum Anwendung finden.

W2W-Verfahren erfordern, dass beide Wafer dieselbe Größe haben und dass die Chips auf beiden Wafern dieselbe Größe haben. Problem dabei ist es, dass die Silizium-Ausnutzung insbesondere bei höheren Chipstapeln unterdurchschnittlich ist (so genannter "Yield"). Auch die erreichbare Chipausbeute an funktionierenden Chips ist niedriger als bei C2C- oder C2W-Verfahren.

Technische Probleme bei der Umsetzung eines C2W-Verfahrens für die Herstellung von Chipstapeln beziehungsweise 3D ICs sind die Handhabung der Wafer, insbesondere mit darauf gestapelten Chips, sowie die unterschiedlichen Anforderungen, insbesondere Temperaturen, für den Stapelprozess und für die Connectoren (Schnittstellen) der Chips zur Montage auf Leiterplatten oder grundsätzlich der übergeordneten Packungseinheit.

Der Handhabung des Basiswafers kommt deshalb so große Bedeutung zu, weil ein Bruch des Basiswafers kurz vor dem Trennen der Vielzahl von Chipstapel auf dem Wafer zu einem Ausschuss von tausenden von teuren Chips führen würde. Die Handhabung des Basiswafers mit einer Vielzahl von darauf fixierten/gebondeten Chipstapeln wird umso schwieriger, je dünner und/oder großflächiger der Basiswafer ist. Als Basiswafer wird der Wafer bezeichnet, auf welchen die Chips im C2W-Verfahren gestapelt werden.

Hier setzt die Erfindung an, deren Aufgabe es ist, ein möglichst ausschussfreies Verfahren zur Herstellung von Chipstapeln (3D ICs) mit möglichst hohem Durchsatz anzugeben.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei der in der Beschreibung, in den Ansprüchen und/oder den Zeichnungen angegebenen Merkmale.

Der Erfindung liegt der Gedanke zu Grunde, den Basiswafer zumindest während des Stapelns von Chips auf den Basiswafer und während der Wärmebehandlung der Chips zum Bonden den Wafer auf einem Träger zu fixieren oder mit einem Träger zu verbinden.

Durch die Fixierung des Basiswafers auf dem Träger wird es mit überraschendem Vorteil für den Durchsatz des C2W-Verfahrens möglich, die Verfahrensschritte des Stapelns beziehungsweise Platzierens der Chips in definierten Positionen auf dem Basiswafer und den/die Verfahrensschritte der Wärmebehandlung beziehungsweise des Bondens der Chips auf den Basiswafer zu trennen. Während die Wärmebehandlung beziehungsweise der Bondingschritt - je nach verwendetem Material - sehr lange dauern kann, ist die Positionierung beziehungsweise Stapelung und Platzierung der Chips auf dem Basiswafer ein Verfahrensschritt, der sehr zügig ablaufen kann, beispielsweise mit mehreren tausend Chips pro Stunde.

Hierdurch kann der Durchsatz erhöht werden, indem mehrere Wärmebehandlungskammern/Bondingstationen vorgesehen sind und/oder mehrere Basiswafer mit gestapelten Chips in einer Wärmebehandlungskammer/Bondingstation verarbeitet werden. Als Wärmebehandlungskammer kommen Hotplates, Durchlauföfen oder Ähnliches in Frage. Ein besonders vorteilhafter Prozess kann mit modifizierten Waferbondkammern realisiert werden, die es erlauben, während des Wärmebehandlungsprozesses Druck auf die Chips auszuüben.

Von besonderem Vorteil im Vergleich zu anderen Verfahren ist die Möglichkeit, dass beim vorliegenden Verfahren Chips unterschiedlicher Größe gestapelt werden können.

Durch die Verwendung eines nicht nur lose mit dem Basiswafer verbundenen Trägers können außerdem Spannungen oder Wölbungen des Basiswafers ausgeglichen werden beziehungsweise diesen entgegen gewirkt werden.

Die Handhabung wird noch weiter vereinfacht, indem der Träger im Wesentlichen der Größe des Basiswafers entspricht, insbesondere im Radius nicht mehr als 10 mm von diesem abweicht.

Besonders bevorzugte Fixiermittel sind Unterdruck oder Vakuum, elektrostatische Mittel, mechanische Klemmung und/oder Kleber, wobei vorzugsweise hitzebeständiger Kleber verwendet wird, um auch bei hohen Temperaturen bei der Wärmebehandlung eine sichere Fixierung des Basiswafers auf dem Träger zu gewährleisten. Kombinationen unterschiedlicher Fixiermittel oder Effekte können dabei - je nach Art der herzustellenden Verbindung oder Höhe des Chipstapels oder wegen sonstiger Faktoren - zu einer weiter verbesserten Handhabung führen.

In einer bevorzugten Ausführungsform der Erfindung erfolgt die Ausrichtung der vertikal benachbarten Chips unmittelbar beim Platzieren der Chips in definierten Positionen, wobei Kontakte der zu platzierenden Chips mit entsprechenden Kontakten der darunter liegenden Schicht von Chips oder Kontakten des Baiswafers ausgerichtet und kontaktiert werden.

Die Chipausbeute kann beim vorliegenden Verfahren mit Vorteil dadurch verbessert werden, dass beim Platzieren von Chips darauf geachtet wird, dass nur auf funktionierende Chips der darunter liegenden Schicht Chips platziert werden. Noch bevorzugter wird die Funktion aller mit dem zu platzierenden Chip funktional verbundenen Chips geprüft und nur bei Funktion aller funktional mit dem Chip zu verbindenden Chips wird ein Chip platziert.

Bei der Wärmebehandlung beziehungsweise dem Bondingschritt werden die elektrisch leitfähigen Verbindungen zwischen den Wafer und dem darauf platzierten Chips beziehungsweise zwischen den platzierten Chips erzeugt. Dabei ist es von Vorteil, wenn das Aufheizen in einer geeigneten Atmosphäre stattfindet, die vorzugsweise frei von Sauerstoff ist, damit Oxidation der Metallkontaktflächen vermieden wird. Insbesondere ist dies durch den Einsatz von einer Stickstoffatmosphäre oder einer anderen inerten Atmosphäre, beispielsweise Argon, erreichbar, wobei für manche Anwendungen besonders vorteilhaft eine nicht nur inerte, sondern auch reduzierende Atmosphäre ist. Diese Eigenschaft kann zum Beispiel durch Formiergas oder Ameisensäuredampf erzielt werden. Formiergas kann dabei durch Mischung von H2 mit N2, insbesondere zwischen 2 % H2 zu 98 % N2 und 15 % H2 zu 85 % N2, gebildet werden. In dieser Mischung kann N2 auch durch andere inerte Gase ersetzt werden.

Damit die Chips nach dem Platzieren der Chips besser zu handhaben sind und nicht verrutschen, ist es von Vorteil, die Chips nach dem Platzieren aufzukleben, vorzugsweise mit einem organischen Kleber, der während dem nachfolgenden Bondingschritt verdampft. Alternativ können die Chips durch eine molekulare Verbindung fixiert werden, die mit Vorteil spontan bei Raumtemperatur entsteht, beispielsweise zwischen Si-Flächen, SiO2-Flächen oder SiN-Flächen.

Der Basiswafer hat in einer besonderen Ausgestaltung der Erfindung, insbesondere durch Rückdünnen, eine Dicke von weniger als 200 µm, insbesondere weniger als 100 µm, vorzugsweise weniger als 50 µm, noch bevorzugter weniger als 20 µm.

Besonders viele Chips finden auf einem Basiswafer mit einem Durchmesser von mindestens 200 mm, insbesondere mindestens 300 mm, vorzugsweise mindestens 450 mm Platz.

In einer besonderen Ausführungsform der Erfindung ist es erst durch die vorliegende Erfindung möglich, Lötperlen (sogenannte "solder bumps" oder "C4-bumps") nach dem Schritt B oder C zur Verbindung jedes Chipstapels mit einer Platine oder grundsätzlich der nächst übergeordneten Packungseinheit aufzubringen.

Die Lötperlen bestehen aus einer Metalllegierung mit niedrigem Schmelzpunkt und dienen generell der Verbindung der Chips/Chipstapel mit anderen elektrischen/elektronischen Bauteilen.

Insbesondere bei Verwendung eines Basiswafers mit den Basiswafer durchsetzenden elektrisch leitenden Verbindungen (TSVs) ist es von Vorteil, die Chips oder Chipstapel nach Schritt B oder C in eine, insbesondere durch hohe thermische und/oder mechanische Stabilität gekennzeichnete, Masse einzugießen, insbesondere eine Masse aus organischem und/oder aus keramischen Material. Besonders bevorzugt ist eine Ausführungsform, bei der zumindest teilweise Epoxidharz in der Masse enthalten ist beziehungsweise die Masse vollständig aus Epoxidharz gebildet ist. In einer besonderen Ausführungsform der Erfindung kann die Epoxidharz enthaltende Masse faserverstärkt sein.

In einer vorteilhaften Ausführungsform der Erfindung wird die Masse nach dem Eingießen mit Druck beaufschlagt, insbesondere durch Entspannung auf Atmosphärendruck nach Durchführen des Eingießens unterhalb des Atmosphärendrucks, vorzugsweise im Vakuum.

Durch die Wirkung der, vorzugsweise duroplastischen, Masse kann der Basiswafer mit Vorteil nach dem Eingießen vom Träger genommen werden.

Die Masse wird in einer bevorzugten Ausführungsform der Erfindung derart bearbeitet, dass die Masse nach dem Eingießen oder während des Eingießens in eine dem Basiswafer korrespondierende Grundform gebracht wird und/oder die Masse bis zur obersten Schicht der Einzelchips abgetragen, insbesondere abgeschliffen wird. Hierdurch wird die weitere Handhabung des aus Basiswafer, eingegossenen Chips und der Masse bestehenden Körpers weiter vereinfacht und es kann insbesondere auf bekannte Konstruktionen für die Handhabung zurückgegriffen werden. Durch das Abtragen der Masse kann mit Vorteil ein Kühlkörper auf die oberste Schicht aufgebracht werden, indem eine präzise plane Oberfläche geschaffen wird.

Eine besonders bevorzugte Ausführungsform der Erfindung besteht darin, dass der Basiswafer und/oder der Träger aus Silizium bestehen, also der Träger ebenfalls ein Wafer ist. Dieser ist mit bekannten Konstruktionen handhabbar und hat den zusätzlichen Vorteil, dass der Wärmeausdehnungskoeffizient des Trägers, soweit Basiswafer und Träger aus Silizium bestehen, identisch ist.

Weitere Vorteile, Merkmale und Einzelheiten der Erfindung ergeben sich aus der nachfolgenden Beschreibung bevorzugter Ausführungsbeispiele sowie an Hand der Zeichnungen. Diese zeigen in:
- Fig. 1:: einen Aufbau einer Anlage zur Ausübung des erfindungsgemäßen Verfahrens,
- Fig. 2a bis 2m:: eine schematische Darstellung eines erfindungsgemäßen Verfahrensablaufes gemäß einer ersten Ausführungsform,
- Fig. 3a:: eine schematische Darstellung eines erfindungsgemäß hergestellten Chipstapels,
- Fig. 3b:: eine schematische Darstellung eines erfindungsgemäßen Chipstapels mit mehreren Chips,
- Fig. 4a bis 4i:: eine schematische Darstellung eines erfindungsgemäßen Verfahrensablaufes gemäß einer zweiten Ausführungsform,
- Fig. 5a:: eine schematische Darstellung eines erfindungsgemäß hergestellten Chips und
- Fig. 5b:: eine schematische Darstellung eines erfindungsgemäß hergestellten Chipstapels mit mehreren Chips.

In den Figuren sind gleiche Bauteile und Bauteile mit der gleichen Funktion mit den gleichen Bezugszeichen gekennzeichnet.

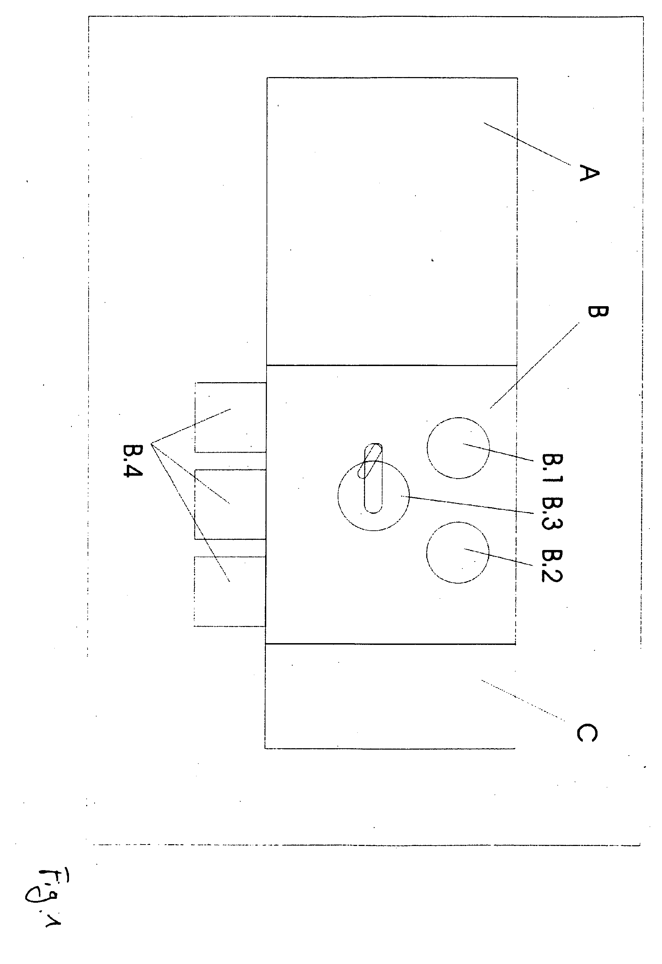

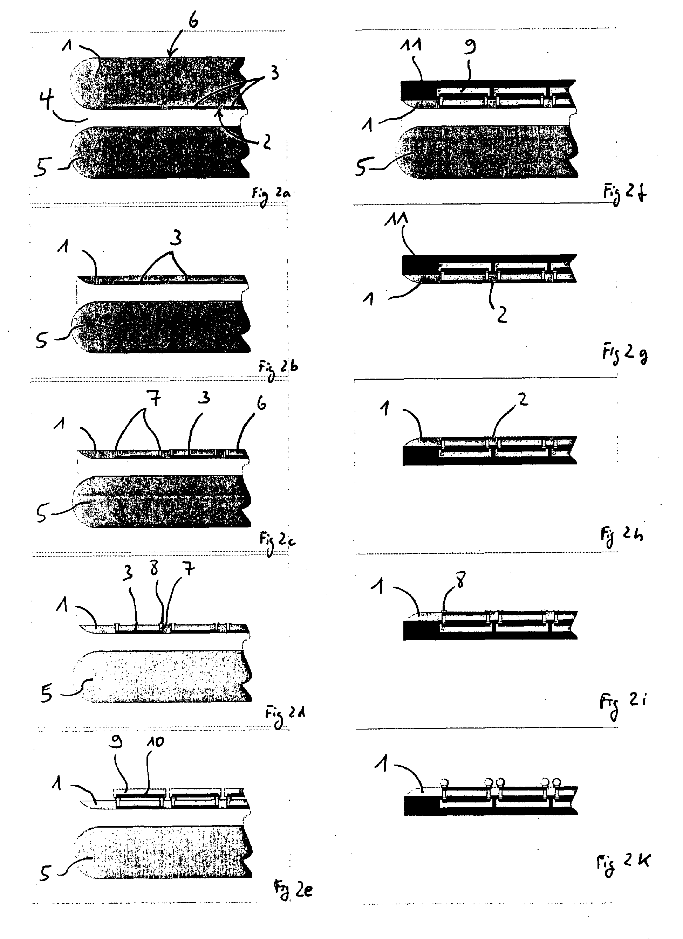

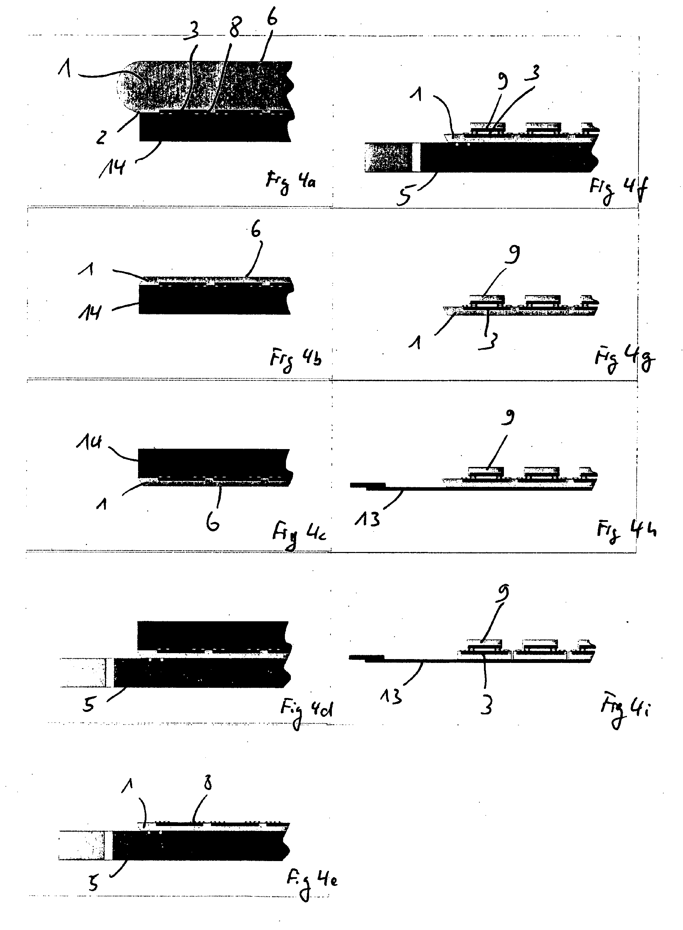

In Figur 1 ist ein schematischer Aufbau einer Anlage zur Ausführung des erfindungsgemäßen Verfahrens dargestellt, wobei im Bereich A die Platzierung der Chipschichten auf dem Basiswafer gemäß Figur 2e oder Figur 4f stattfindet, nachdem der Basiswafer auf der Station B.1 oder anderweitig, beispielsweise vormontiert, auf den Träger montiert wurde und auf der Folienabziehstation B.2 eine von einem vorherigen Rückdünnprozess vorhandene Rückdünnfolie (back grinding tape) abgezogen wurde.

Die Handhabung des Trägers mit dem Basiswafer erfolgt über einen Roboter B.3 mit Roboterarm.

An dem Handhabungsmodul B ist eine Kassettenstation B.4 vorgesehen, von der für das Verfahren notwendiges Material entnommen wird beziehungsweise wieder abgegeben wird.

Nach Platzierung der Chips im Chipplatzierungssystem A wird der Träger mit dem Basiswafer und den auf dem Basiswafer gestapelten Chips, die gegebenenfalls über einen Kleber fixiert sind, zu der Bondingstation C zur Wärmebehandlung beziehungsweise zum Bonden der Chips auf dem Basiswafer geführt. Während der Wärmebehandlung beziehungsweise während des Bondens kann bereits der nächste Basiswafer mit Chips bestückt werden. Die Bondingstation C kann auch aus mehreren Bondingeinheiten bestehen, da das Bonden - je nach Anforderungsprofil - insbesondere im Vergleich zum Platzieren der Chips erhebliche Zeit in Anspruch nehmen kann.

Weitere Behandlungsschritte der auf dem Basiswafer gebondeten Chipstapel, wie beispielsweise das Trennen der Chipstapel in einem Dicing-Modul sind in Figur 1 nicht dargestellt, können sich aber an die Bondingstation C anschließen oder vorzugsweise im Bereich des Handhabungsmoduls B, also in Figur 1 oberhalb des Handhabungsmoduls B angeordnet sein, damit die Handhabung des Chipstapels über den Roboterarm möglich ist. In einer bevorzugten Ausführungsform der Erfindung kann der Träger auch im Dicing-Modul noch zum Einsatz kommen, wodurch der Chipstapel auch nach dem Bonden mit dem Basiswafer weiterhin sicher gehandhabt werden kann.

In Figur 2a ist ein aus Silizium bestehender Basiswafer 1 dargestellt, dessen Vorderseite 2 durch vorherige Behandlungsschritte mit Chips 3 bestückt ist, die in die Oberfläche 2 bündig eingearbeitet sind.

Über Verbindungsmittel 4 wird der Basiswafer 1 mit einem Träger 5, hier ebenfalls einem aus Silizium bestehenden Wafer, verbunden, um gemäß Figur 2b von der Rückseite 6 des Basiswafers 1 her rückgedünnt werden zu können.

Gemäß Figur 2c werden im Bereich jedes Chips 3 von der Rückseite 6 des Basiswafers 1 elektrische Verbindungen 7 hergestellt, die von der Rückseite 6 des Basiswafers 1 bis zum jeweiligen Chip 3 reichen.

Auf die Rückseite 6 des Basiswafers 1 werden zur elektrischen Kontaktierung weiterer Einzelchips 9 elektrisch leitende Plättchen 8 auf die elektrisch leitenden Verbindungen 7 aufgebracht (siehe Figur 2d). In speziellen Ausführungsformen der Erfindung können die Chips auch direkt mit den elektrisch leitfähigen Verbindungen 7 kontaktiert werden oder andere elektrisch leitende Anknüpfungspunkte hergestellt werden. Die Einzelchips 9 sind aus je einem Chip 3 und einer den Chip 3 aufnehmenden Halterung gebildet, die aus Silizium besteht.

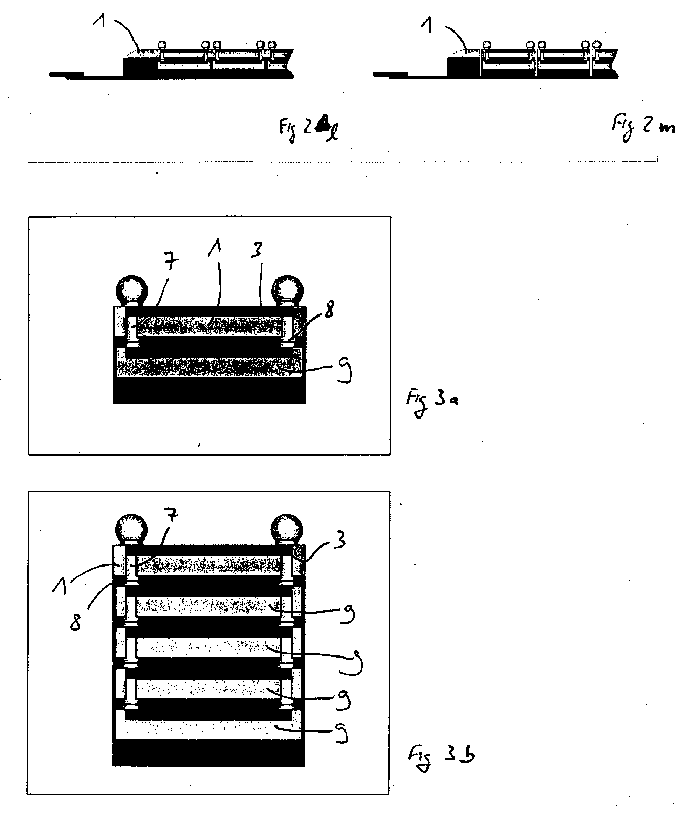

Gemäß Figur 2e werden die Einzelchips 9 mit deren Chipseite 10 auf die elektrisch leitenden Plättchen 8 aufgebracht, wobei die Schritte 2c bis 2e gegebenenfalls mehrfach wiederholt werden können, um eine Vielzahl von Einzelchips 9 aufeinander zu stapeln (siehe Figur 3b). Diese Prozessabfolge kann mit oder ohne Wärmebehandlungsschritt beziehungsweise Bondschritt zwischen den einzelnen Platzierungsschritten erfolgen. Die Platzierung der Einzelchips 9 auf dem Basiswafer 1 erfolgt auf der Chipplatzierungsstation A.

Im Verfahrensschritt gemäß Figur 2f werden die Einzelchips 9 beziehungsweise gegebenenfalls mehrere Schichten von Einzelchips 9 in eine Masse 11 eingegossen, im vorliegenden Ausführungsbeispiel Epoxidharz.

Nach dem Bonden der Chips und Aushärten der Masse 11 kann der Träger 5 entfernt werden, da durch die Masse 11 eine ausreichende Stabilisierung des dünnen und großflächigen Basiswafers 1 erfolgt. Das Ablösen des Trägers 5 kann automatisch durch Lösen des Verbindungsmittels in dem Eingießschritt gemäß Figur 2f (hitzeabhängig) erfolgen. Weiterhin kann es vorteilhaft sein, den Ablöseschritt separat in einem nachgeschalteten Prozessschritt durchzuführen, wobei der Ablöseschritt entweder thermisch, chemisch oder durch Einwirkung einer externen Energiequelle (beispielsweise UV-Licht, Infrarotlicht, Laser oder Mikrowelle) ausgelöst werden kann.

Im Verfahrensschritt gemäß Figur 2h ist der Basiswafer 1 gedreht worden, so dass die Vorderseite 2 nunmehr nach oben zeigt.

In einem weiteren Verfahrensschritt gemäß Figur 2i werden wieder elektrisch leitende Plättchen 8 auf die nunmehr oben liegenden Chips 3 aufgebracht, um gemäß Figur 2k Lötperlen 12 aufzubringen. Die Lötperlen 12 dienen dem späteren Anschluss der Chips (3D ICs) an Platinen oder die nächst übergeordnete Packungseinheit/Chipschicht.

Als Material für die Verbindung zwischen den Chips 3 kommt eine Reihe von Varianten in Frage. Grundsätzlich kann man zwischen metallischen Verbindungen, organischen Verbindungen, anorganischen Verbindungen und Hybridverbindungen unterscheiden. Im Bereich der metallischen Verbindungen kommen Metalldiffusionsverbindungen, eutektische Verbindungen, die während dem Bonden entstehen und Eutektika in Frage, die schon vor dem Bonden vorhanden waren und während des Bondens ermöglichen, die Legierung zu schmelzen. Letztere sind auch die Lötperlen 12, die in Form von Kugeln auf den Wafer aufgebracht werden und das Herstellen der Verbindungen praktisch ohne Druckausübung ermöglichen. Es kommen auch leitfähige Polymere in Frage.

Im Verfahrensschritt gemäß Figur 2l wird der Basiswafer mit den Chipstapeln und Lötperlen 12 auf einen Trennrahmen 13 (Dicing Frame) abgelegt, um anschließend gemäß Figur 2m die Chipstapel voneinander zu trennen (Dicing).

Zwei Beispiele für gemäß dem vorbeschriebenen Verfahren hergestellte Chipstapel sind in Figur 3a und Figur 3b abgebildet, wobei in Figur 3a lediglich ein Einzelchip 9 auf den Chip 3 des Basiswafers 1 montiert wurde, während im Chipstapel gemäß Figur 3b vier Einzelchips 9 auf den Basiswafer 1 montiert wurden.

In Figur 4a ist ein auf eine Rückdünnfolie 14 geklebter Basiswafer 1 dargestellt, der bereits mit Chips 3 und elektrisch leitenden Plättchen 8 versehen ist, und zwar auf der Vorderseite 2 des Basiswafers 1.

Im Verfahrensschritt gemäß Figur 4b wird der Basiswafer 1 von der Rückseite 6 her rückgedünnt und in Figur 4c gedreht, so dass die Rückseite 6 des Basiswafers 1 nach unten zeigt.

Im Verfahrensschritt gemäß Figur 4d wird der Basiswafer 1 mit seiner Rückseite 6 auf einen Träger 5 fixiert und anschließend wird die Rückdünnfolie 14 von der Vorderseite 2 des Basiswafers 1 abgelöst (siehe Figur 4e).

Im darauf folgenden Verfahrensschritt gemäß Figur 4f werden Einzelchips 9 in der Chipplatzierungsstation A gemäß Figur 1 auf entsprechende elektrisch leitende Plättchen 8 auf den Chips 3 des Basiswafers 1 platziert und gegebenenfalls fixiert.

Nachdem die Chipstapel platziert und gegebenenfalls fixiert sind, wird der Basiswafer 1 mit den Chipstapeln auf den Trennrahmen 13 aufgebracht, um die einzelnen Chipstapel voneinander zu trennen (siehe Figuren 4g, 4h und 4i).

Der Basiswafer 1 kann bevorzugt auch mit dem Träger 5 auf den Trennrahmen 13 aufgebracht werden, um einen Bruch des Basiswafers 1 und eine Beschädigung der Chips zu vermeiden.

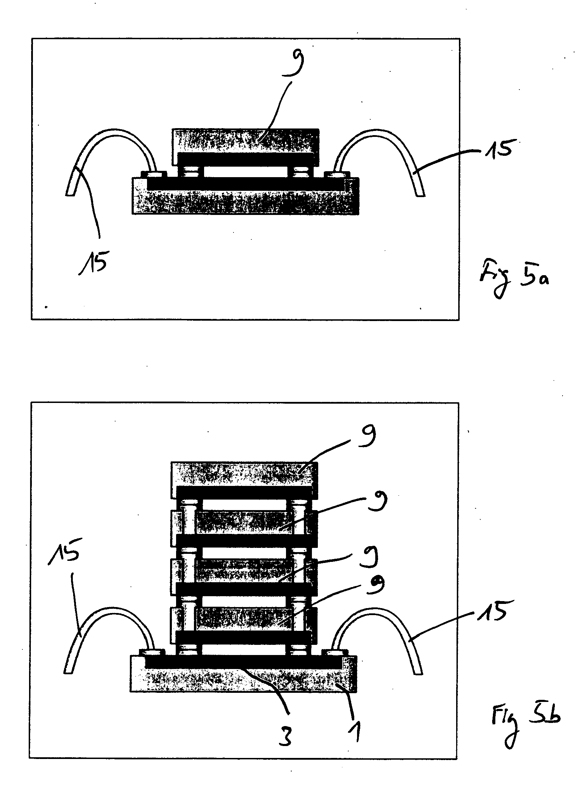

In Figuren 5a und 5b sind Beispiele für fertige Chipstapel dargestellt, die im Gegensatz zu den in Figuren 3a und 3b dargestellten Chipstapeln über mit den Chips 3 elektrisch leitend verbundene Leitungsanschlüsse 15, meist in Form von Drähten, an eine (nicht dargestellte) Platine oder an Kontakte eines finalen Chipgehäuses (auch als "lead frame" bekannt) angeschlossen werden können.

### Bezugszeichenliste

- A: Chipplatzierungsstation
- B: Handhabungsmodul
- B.1: Transferstation
- B.2: Folienabziehstation
- B.3: Roboter mit Roboterarm
- B.4: Kassettenstation
- C: Bondingstation

- 1: Basiswafer
- 2: Vorderseite
- 3: Chips
- 4: Verbindungsmittel
- 5: Träger
- 6: Rückseite
- 7: elektrisch leitende Verbindung
- 8: elektrisch leitende Plättchen
- 9: Einzelchips
- 10: Chipseite
- 11: Masse
- 12: Lötperlen
- 13: Trennrahmen
- 14: Rückdünnfolie
- 15: Leitungssatz

## Patentansprüche

1. Verfahren zum Bonden einer Vielzahl von Chips (3) auf einen Basiswafer (1), wobei die Chips (3) in mehreren Schichten über dem Basiswafer (1) gestapelt werden und zwischen den vertikal benachbarten Chips (3) sowie dem Basiswafer (1) und der dem Basiswafer (1) vertikal benachbarten Schicht von Chips (3) elektrisch leitfähige Verbindungen (7) bestehen, mit folgenden Schritten in der genannten Reihenfolge:
a) Fixieren des Basiswafers (1) auf einem Träger (5),
b) Platzieren mindestens einer Schicht von Chips (3) in definierten Positionen auf dem Basiswafer (1) und
c) Wärmebehandlung der Chips (3) auf dem mit dem Träger (5) fixierten Basiswafer (1).

2. Verfahren nach Anspruch 1, bei dem Schritt b) und c) in unterschiedlichen Geräten ausgeführt werden.

3. Verfahren nach einem der vorhergehenden Ansprüche, bei dem der Träger (5) aus zumindest teilweise Silizium besteht und im Wesentlichen der Größe des Basiswafers (1) entspricht, insbesondere im Radius nicht mehr als 10mm, insbesondere 5mm, vorzugsweise 2mm, noch bevorzugter 1mm von diesem abweicht.

4. Verfahren nach einem der vorhergehenden Ansprüche, bei dem zum Fixieren Fixiermittel, insbesondere Vakuum, elektrostatische Mittel, mechanische Klemmung und/oder Kleber, vorzugsweise hitzebeständige Kleber, verwendet werden.

5. Verfahren nach einem der vorhergehenden Ansprüche, bei dem Chips (3) beim Platzieren in definierten Positionen mit Kontakten der entsprechenden Kontakte der darunter liegenden Schicht von Chips oder des Basiswafers ausgerichtet und kontaktiert werden.

6. Verfahren nach einem der vorhergehenden Ansprüche, bei dem Chips (3) beim Platzieren nur auf funktionierende Chips (3) der darunter liegenden Schicht platziert werden.

7. Verfahren nach einem der vorhergehenden Ansprüche, bei dem die Wärmebehandlung in einer Atmosphäre frei von Sauerstoff erfolgt, insbesondere in einer inerten Atmosphäre, vorzugsweise in einer reduzierenden Atmosphäre, noch bevorzugter in einer Atmosphäre aus Formiergas oder Ameisensäure.

8. Verfahren nach einem der vorhergehenden Ansprüche, bei dem die Chips (3) nach dem Platzieren aufgeklebt, vorzugsweise mit einem organischen Kleber, oder durch molekulare Verbindung fixiert werden.

9. Verfahren nach einem der vorhergehenden Ansprüche, bei dem der Basiswafer (1) eine Dicke weniger als 200µm, insbesondere weniger als 100µm, vorzugsweise weniger als 50µm, noch bevorzugter weniger als 20µm aufweist.

10. Verfahren nach einem der vorhergehenden Ansprüche, bei dem der Basiswafer (1) einen Durchmesser von mindestens 200mm, insbesondere mindestens 300mm, vorzugsweise mindestens 450mm aufweist.

11. Verfahren nach einem der vorhergehenden Ansprüche, bei dem die Chips (3) oder Chipstapel nach Schritt b) oder c) in eine, insbesondere durch hohe thermische und/oder mechanische und/oder chemische Stabilität und/oder wasserabweisende Eigenschaften gekennzeichnete, Masse (11) eingegossen werden, insbesondere aus organischem, vorzugsweise Epoxidharz, oder aus keramischem Material.

12. Verfahren nach Anspruch 11, bei dem die Masse (11) nach dem Eingießen mit Druck beaufschlagt wird, insbesondere durch Entspannung auf Atmosphärendruck nach Durchführen des Eingießens unterhalb des Atmosphärendrucks, vorzugsweise im Vakuum.

13. Verfahren nach einem der Ansprüche 11 oder 12, bei dem die Masse (11) in flüssiger Form bei Raumtemperatur oder bei höherer Temperatur eingegossen wird.

14. Verfahren nach einem Ansprüche 12 oder 13, bei dem der Basiswafer (1) nach dem Eingießen vom Träger (5) genommen wird.

15. Verfahren nach einem oder mehreren der Ansprüche 12 bis 14, bei dem der Basiswafer (1) mit der Masse (11) und den in der Masse (11) eingegossenen Chips (3) nach dem Eingießen oder während des Eingießens in eine dem Basiswafer (1) korrespondierende Grundform gebracht wird und/oder die Masse (11) bis zur obersten Schicht der Einzelchips (9) abgetragen, insbesondere abgeschliffen wird.

16. Verfahren nach einem der vorhergehenden Ansprüche, bei dem nach dem Schritt b) oder c), insbesondere nach dem Eingießen, Lötperlen (12) zur Verbindung jedes Chipstapels mit einer Platine oder einem weiteren Chipstapel aufgebracht werden.

17. Verfahren nach einem der vorhergehenden Ansprüche, bei dem der Basiswafer (1) und/oder der Träger (5) aus Silizium bestehen.

18. Verfahren nach einem der vorhergehenden Ansprüche, bei dem mindestens zwei Schichten Chips (3) auf den Basiswafer (1) aufgebracht werden.

19. Verfahren nach einem der Ansprüche 1 bis 10, bei dem die Chips (3) oder Chipstapel nach Schritt b) oder c) mit einer Masse (11), insbesondere einem thermoplastischen Material, heißgeprägt werden.

20. Verfahren nach einem der vorhergehenden Ansprüche, bei dem der Basiswafer (1) mit den darauf gestapelten Chips (3) auf einem Trennrahmen (13) fixiert wird, bevor der Basiswafer (1) von dem Träger (5) getrennt wird.
